# EUROPÄISCHE PATENTSCHRIFT

(11) **EP 3 026 703 B1**
(45) Veröffentlichungstag und Bekanntmachung des Hinweises auf die Patenterteilung: **20.11.2019**
(21) Anmeldenummer: 15195788.3
(22) Anmeldetag: 23.11.2015
(51) Int. Cl.: H01L 23/498, H01L 23/00

(54) **VERFAHREN ZUM HERSTELLEN EINES SUBSTRATADAPTERS, SUBSTRATADAPTER UND VERFAHREN ZUM KONTAKTIEREN EINES HALBLEITERELEMENTS**
METHOD FOR PRODUCING A SUBSTRATE ADAPTER, SUBSTRATE ADAPTER AND METHOD FOR CONTACTING A SEMICONDUCTOR ELEMENT
PROCÉDÉ DE FABRICATION D'UN ADAPTATEUR DE SUBSTRAT, ADAPTATEUR DE SUBSTRAT ET PROCÉDÉ DE MISE EN CONTACT D'UN ÉLÉMENT SEMI-CONDUCTEUR

(30) Priorität: 25.11.2014 DE 102014117246
(43) Veröffentlichungstag der Anmeldung: 01.06.2016
(73) Patentinhaber: Heraeus Deutschland GmbH & Co. KG, 63450 Hanau (DE)
(72) Erfinder: BLEIFUSS, Martin, 63796 Kahl (DE); HINRICH, Andreas, 63579 Freigericht (DE); KLEIN, Andreas, 63579 Freigericht (DE); SCHÄFER, Michael, 36093 Künzell (DE); KRILL, Elisa, 63768 Hösbach (DE); BACHMANN, Christian, 6430 Nordborg (DK); ULRICH, Holger, 6430 Nordborg (DK); OSTERWALD, Frank, 6430 Nordborg (DK); BENNING, David, 6430 Nordborg (DK); RUDZKI, Jacek, 6430 Nordborg (DK); PAULSEN, Lars, 6430 Nordborg (DK); SCHEFUSS, Frank, 6430 Nordborg (DK); BECKER, Martin, 6430 Nordborg (DK)
(74) Vertreter: Kilchert, Jochen

(56) Entgegenhaltungen:
- WO-A1-2013/037184
- DE-A1- 10 003 671
- US-A1- 2014 225 152

## Beschreibung

Die Erfindung betrifft ein Verfahren zum Herstellen eines Substratadapters, der insbesondere zum Kontaktieren eines Halbleiterelements dient. Daneben betrifft die Erfindung einen Substratadapter und ein Verfahren zum Kontaktieren eines Halbleiterelements, insbesondere eines Leistungsbauelements, bei dem ein Substratadapter zum Einsatz kommt. US 2014/225152 beschreibt einen im Stand der Technik bekannten Substratadapter.

Steigende Anforderungen in Leistungselektronik-Modulen, die beispielsweise die Leitfähigkeiten und die Lebensdauer betreffen, erfordern den Einsatz von Cu-Bond-Drähten zur Kontaktierung von Leistungshalbleitern untereinander oder anderen Anschlüssen innerhalb eines Leistungselektronik-Moduls. Als Chip-Metallisierung wird derzeit überwiegend eine Aluminium-Beschichtung bzw. Aluminium-Metallisierung verwendet, wobei dies zu Problemen im Kontaktierungsprozess und in der späteren Anwendung führen kann. Beispielsweise kann es aufgrund einer derartigen Metallisierung zu späteren Ausfällen im Betrieb kommen.

Es existieren verschiedene Lösungsansätze zur Steigerung der Systemlebensdauer, so z.B. die Verwendung von sogenannten Flex-Leiterplatten. Allerdings sind auch derartige Flex-Leiterplatten mit einem Nachteil verbunden, da diese nicht mit einem konventionellen Draht-Bond-Prozess kontaktiert werden können, so dass bestehende Produktionskapazitäten nicht mehr genutzt werden können.

Die Aufgabe der vorliegenden Erfindung ist es, eine, insbesondere hinsichtlich der Zuverlässigkeit der hergestellten Halbleitereinrichtungen, insbesondere Leistungshalbleiter-Einrichtungen, verbesserte Lösung bereitzustellen. Außerdem soll ein Verfahren angegeben werden, welches insbesondere hinsichtlich einer nachgelagerten bzw. nachgeschalteten Pick-and-Place-Technologie mit Verbesserungen einhergeht.

Erfindungsgemäß wird diese Aufgabe im Hinblick auf ein Verfahren zum Herstellen eines Substratadapters, der insbesondere zum Kontaktieren von Halbleiterelementen dient, durch ein Verfahren mit Merkmalen des Patentanspruches 1, im Hinblick auf den Substratadapter durch den Gegenstand des Patentanspruches 9 und im Hinblick auf das Verfahren zum Kontaktieren eines Halbleiterelements, insbesondere Leistungsbauelements, mittels eines erfindungsgemäßen Substratadapters durch ein Verfahren mit den Merkmalen des Patentanspruches 15 gelöst.

Vorteilhafte und zweckmäßige Ausgestaltungen des erfindungsgemäßen Verfahrens zum Herstellen eines Substratadapters bzw. des erfindungsgemäßen Verfahrens zum Kontaktieren eines Halbleiterelements sowie des erfindungsgemäßen Substratadapters sind in den Unteransprüchen angegeben.

Das erfindungsgemäße Verfahren zum Herstellen eines Substratadapters, der insbesondere zum Kontaktieren von Halbleiterelementen dient, umfasst die Schritte:
- Strukturieren eines elektrisch leitenden Metallelements,
- zumindest abschnittsweises Ummanteln des strukturierten Metallelements mit einem elektrisch isolierenden Material, insbesondere Kunststoff, und
- Aufbringen eines Kontaktierungsmaterials auf eine erste Seite des Metallelements.

Das Strukturieren eines elektrisch leitenden Metallelements betrifft das Einarbeiten von Strukturen in ein elektrisch leitendes Metallelement, wobei die Strukturen sowohl auf einer als auch auf mehreren Seiten eines elektrisch leitenden Metallelements eingearbeitet werden können. Beispielsweise erfolgt das Strukturieren eines elektrisch leitenden Metallelements im Hinblick auf die zu erlangende Form eines Substratadapters bzw. die zu erlangende Form eines Kontaktierungsmaterials. Es ist z.B. möglich, dass in ein elektrisch leitendes Metallelement im Abstand zueinander gleichartige bzw. übereinstimmende Formen eingearbeitet werden.

Das elektrisch leitende Metallelement kann eine Metallfolie, insbesondere eine Kupferfolie, sein. Das Metallelement kann außerdem aus einer Kupferlegierung gebildet sein. Diesbezüglich ist es denkbar, dass CuNi, CuSn, CuFe, CuNiSz, CuAg, CuW oder CuMo verwendet wird. Außerdem ist es möglich, dass das Metallelement aus reinem Silber besteht.

Optional kann es vorgesehen sein, dass die erste Seite des strukturierten Metallelements mit einem ersten Beschichtungssystem und/oder die zweite Seite des strukturierten Metallelements mit einem zweiten Beschichtungssystem beschichtet wird. Das optionale Beschichten der ersten und/oder der zweiten Seite des Metallelements mit einem ersten und/oder einem zweiten Beschichtungssystem kann beispielsweise mittels Galvanisierung durchgeführt werden. Die Beschichtung bzw. das erste und/oder das zweite Beschichtungssystem sind vorzugsweise unterschiedliche Metalle, insbesondere Nickel, Silber und/oder Gold.

Bei dem erfindungsgemäßen Verfahren wird das strukturierte Metallelement zumindest abschnittsweise mit einem elektrisch isolierenden Material, insbesondere Kunststoff, ummantelt. Das erfindungsgemäße Verfahren zeichnet sich also dadurch aus, dass das Metallelement aufgrund einer Ummantelung mit elektrisch isolierendem Material zum einen hinsichtlich der elektrischen Isolation während des Herstellungsverfahrens verbessert wird und des Weiteren ein stabilisiertes Zwischen- bzw. Endprodukt zur Verfügung gestellt wird.

Bei dem erfindungsgemäßen Verfahren kann es vorgesehen sein, dass das strukturierte Metallelement mit einem Träger und dem Kontaktierungsmaterial gefügt bzw. zusammengefügt wird.

Es kann ein Vereinzeln des strukturierten und mit Kontaktierungsmaterial versehenen Metallelements zur weiteren Verarbeitung derart durchgeführt werden, dass der Träger die vereinzelten Metallelemente in einem Abstand zueinander fixiert. Auf einem Träger befinden sich demnach mehrere vereinzelte Metallelemente, die mit Kontaktierungsmaterial versehen sind, wobei die Metallelemente auf dem Träger nebeneinander angeordnet sind, wobei der Abstand der vereinzelten Metallelemente auf dem Träger zueinander beibehalten bleibt. Der Träger bewirkt, dass vereinzelte Metallelemente in Lage gehalten werden.

Mit einer Weiterbildung der Erfindung wird vorgeschlagen, dass auf die zweite Seite des strukturierten Metallelements, vorzugsweise vor dem Vereinzeln des strukturierten und mit Kontaktierungsmaterial versehenen Metallelements, eine Schutzfolie aufgebracht wird. Mit Hilfe der Schutzfolie kann die zweite Seite des strukturierten Metallelements vor einer elektrischen Kontaktierung und/oder einer Verschmutzung und/oder einer Beschädigung geschützt werden.

Das zumindest abschnittsweise Ummanteln des strukturierten Metallelements mit elektrisch isolierendem Material kann durch ein Transfermolden, insbesondere Film-Assist-Molden oder Thermo-Compression-Molden, oder durch ein Injection-Molden, insbesondere Mikrospritzen, erfolgen. In Abhängigkeit des gewählten Mold-Verfahrens können unterschiedliche Mold-Materialien verwendet werden. Beim Injection-Molden können thermoplastische Materialien, wie z.B. PPE oder PEEK verwendet werden. Bei einem Transfermolden werden vorzugsweise Duroplaste verwendet. Des Weiteren ist es denkbar, dass die Mold-Materialien mit Füllstoffen wie z.B. Glasfaserelementen versehen sind.

Beim Ummanteln des strukturierten Metallelements werden zumindest abschnittsweise Seitenflächen des Metallelements mit elektrisch isolierendem Material bedeckt, wobei ein Rahmen aus elektrisch isolierendem Material gebildet wird. Bei den Seitenflächen eines Metallelements handelt es sich um die Flächen, welche die Dicke eines strukturierten Metallelements bilden. Mit anderen Worten sind die Seitenflächen eines strukturierten Metallelements die Flächen, welche die Dicke bzw. Höhe einer Metallfolie bilden. Die Seitenflächen eines strukturierten Metallelements können auch als Randflächen bezeichnet werden.

Aufgrund eines derartig gebildeten Rahmens ist das strukturierte Metallelement beispielsweise korrosionsgeschützt ausgebildet. Des Weiteren wird ein sehr robustes Zwischenelement gebildet, welches bei einem nachgelagerten Pick-and-Place-Prozess in vorteilhafter Weise transportiert werden kann, da die Durchschlagsspannung aufgrund des Rahmens erhöht ist.

Der Rahmen aus elektrisch isolierendem Material kann zwischen zwei Abschnitten des strukturierten Metallelements mindestens einen Trennsteg aus elektrisch isolierendem Material umfassen. Sofern bei der Strukturierung und anschließenden Vereinzelung des Metallelements ein Gate und ein Emitter gebildet wird, kann der Trennsteg zwischen den beiden Abschnitten des strukturierten Metallelements, also zwischen dem Gate und dem Emitter ausgebildet werden. Der Trennsteg ist als Teil bzw. Abschnitt des Rahmens zu verstehen. Mit Hilfe eines derartigen Trennstegs kann ein definierter Abstand zwischen einem Gate und einem Emitter gebildet werden.

Die Höhe des Rahmens aus elektrisch isolierendem Material, insbesondere Kunststoff, kann der Dicke des Metallelements entsprechen. Bei einer derartigen Ausbildung des Rahmens ist es möglich, dass das Metallelement bündig mit dem Rahmen abschließt.

Mit der Erfindung wird auch vorgeschlagen, dass der Rahmen auf der ersten Seite des Metallelements eine Kavität mit Begrenzungsflächen bildet, in die das Kontaktierungsmaterial eingebracht wird. Derartige Kavitäten dienen als Positionierungshilfe für ein aufzubringendes Kontaktierungsmaterial. Der Rahmen kann des Weiteren zumindest abschnittsweise Kanten der ersten Seite und/oder der zweiten Seite des Metallelements hintergreifen. Ein derartiges Hintergreifen von Kanten der ersten und/oder der zweiten Seite des Metallelements stabilisiert das Metallelement zusätzlich. Dies hat zur Folge, dass auch die Kanten und/oder Eckabschnitte des Metallelements mit einem Kunststoff beschichtet bzw. ummantelt sein können.

Erfindungsgemäß kann ferner vorgesehen sein, dass die Höhe mindestens einer der Begrenzungsflächen kleiner als die Dicke des Kontaktierungsmaterials ist oder größer als die Dicke des Kontaktierungsmaterials ist oder der Dicke des Kontaktierungsmaterials entspricht. Wenn die Dicke des Kontaktierungsmaterials der Höhe der Begrenzungsfläche entspricht, schließt das Kontaktierungsmaterial auf der ersten Seite des Metallelements bündig mit den Begrenzungsflächen und somit dem Rahmen aus elektrisch isolierendem Material ab. Sofern die Höhe einer der Begrenzungsflächen kleiner als die Dicke des Kontaktierungsmaterials ist, steht das Kontaktierungsmaterial auf der ersten Seite des Metallelements zumindest abschnittsweise über den Rahmen hinaus bzw. über. Wenn die Höhe mindestens einer der Begrenzungsflächen größer als die Dicke des Kontaktierungsmaterials ist, steht der Rahmen zumindest abschnittsweise über das Kontaktierungsmaterial, wobei diesbezüglich bewirkt wird, dass beispielsweise ein Träger und/oder eine Trägerfolie auf dem Rahmen aufliegt.

In einer weiteren Ausführungsform der Erfindung kann mindestens ein Trennsteg des Rahmens mit einer Begrenzungsfläche verbunden sein, wobei die Höhe dieser Begrenzungsfläche kleiner als die Dicke des Kontaktierungsmaterials ist.

Erfindungsgemäß kann ferner vorgesehen sein, dass die Begrenzungsflächen derart gebildet werden, dass diese mit der ersten Seite des Metallelements einen Winkel von mindestens 90° einschließen, um eine Positionierungsgeometrie für das einzubringende Kontaktierungsmaterial zu bilden.

Das Aufbringen des Kontaktierungsmaterials auf die erste Seite des Metallelements kann folgende Schritte umfassen:
- Aufbringen, insbesondere Siebdrucken oder Schablonendrucken, auf eine Seite eines Trägers,
- Positionieren des abschnittsweise ummantelten Metallelements und des Trägers derart, dass die erste Seite des Metallelements und das Kontaktierungsmaterial gegenüber angeordnet sind, und
- Fügen des strukturierten Metallelements mit dem Träger und dem auf dem Träger befindlichen Kontaktierungsmaterial.

Ein derartiges Verfahren kann als indirektes Drucken bezeichnet werden.

Das Aufbringen des Kontaktierungsmaterials kann direkt auf die erste Seite des Metallelements beispielsweise durch Siebdrucken oder Schablonendrucken erfolgen. Bevorzugt ist ein derartiges Aufbringen des Kontaktierungsmaterials in den Fällen auszuführen, in denen die Höhe des Rahmens der Dicke des Metallelements entspricht.

Außerdem kann ferner vorgesehen sein, dass das Kontaktierungsmaterial direkt auf die erste Seite des Metallelements durch Rakeln oder Sprayen der Jetten oder Dispensen in die mindestens eine Kavität aufgebracht wird. Vorzugsweise ist diese Art des Aufbringens des Kontaktierungsmaterials dann zu wählen, wenn der Rahmen nicht bündig mit dem Metallelement abschließt sondern Kavitäten gebildet sind. Es kann vorgesehen sein, die Kavitäten vollständig mit dem Kontaktierungsmaterial zu verfüllen. Außerdem ist es denkbar, die Kavitäten hinsichtlich ihrer Höhe bzw. Tiefe nur abschnittsweise mit Kontaktierungsmaterial zu verfüllen bzw. aufzufüllen. Demnach wird mit der Erfindung auch vorgeschlagen, dass beim Ummanteln des strukturierten Metallelements zumindest abschnittsweise die in das Metallelement eingebrachte Struktur mit elektrisch isolierendem Material aufgefüllt und/oder abschnittsweise aufgefüllt wird. Die in ein Metallelement eingebrachte Struktur kann beispielsweise eine Ausnehmung und/oder ein Graben und/oder eine Nut sein, wobei diese Ausnehmung, der Graben sowie die Nut beispielsweise vollständig mit einem elektrisch isolierenden Material aufgefüllt ist. Auch das hinsichtlich der Ausnehmungs-, Nut- oder Grabentiefe abschnittsweise Auffüllen mit elektrisch isolierendem Material ist denkbar.

Bei dem Kontaktierungsmaterial kann es sich beispielsweise um ein sinterbares Material bzw. um ein Sintermaterial handeln. Das Kontaktierungsmaterial kann eine Sinterpaste und/oder eine Sinterfolie sein, wobei das Sintermaterial und/oder die Sinterpaste und/oder die Sinterfolie beispielsweise Silber und/oder eine Silberverbindung enthalten kann. Außerdem ist es denkbar, dass das Kontaktierungsmaterial ein Lot und/oder ein Leitkleber ist.

In einem nebengeordneten Aspekt betrifft die Erfindung einen Substratadapter, der ein Metallelement mit einer ersten und einer zweiten Seite, ein auf der ersten Seite aufgebrachtes Kontaktierungsmaterial und einen äußeren Rahmen aus elektrisch isolierendem Material, der zumindest abschnittsweise Seitenflächen des Metallelements bedeckt, umfasst.

In einer Weiterbildung der Erfindung kann der Rahmen zwischen zwei Abschnitten des strukturierten Metallelements mindestens einen Trennsteg aus elektrisch isolierendem Material umfassen. Ein derartiger Trennsteg ist vor allen Dingen als definierter Abstandshalter zwischen einem Gate und einem Emitter, die durch zwei Abschnitte des Metallelements gebildet werden, zu verstehen. Die beiden Abschnitte sind demnach zueinander elektrisch isoliert angeordnet.

Mit dem erfindungsgemäßen Substratadapter wird des Weiteren vorgeschlagen, dass der Rahmen zumindest abschnittsweise Kanten der ersten und/oder der zweiten Seite des Metallelements hintergreift. Dies führt zu einer zusätzlichen Versteifung des Substratadapters, der äußerst robust ausgebildet ist und somit mittels einer Pick-and-Place-Technologie transportiert werden kann.

Auf der ersten Seite des Metallelements kann eine Kavität mit Begrenzungsflächen gebildet sein, in die das Kontaktierungsmaterial eingebracht ist. Außerdem ist es möglich, dass die Höhe mindestens einer der Begrenzungsflächen kleiner als die Dicke des Kontaktierungsmaterials ist oder größer als die Dicke des Kontaktierungsmaterials ist oder der Dicke des Kontaktierungsmaterials entspricht. Es ergeben sich ähnliche Vorteile, wie diese bereits im Zusammenhang mit dem erfindungsgemäßen Verfahren erläutert sind.

Mindestens ein Trennsteg kann mit einer Begrenzungsfläche einer Kavität verbunden sein, wobei die Höhe der Begrenzungsfläche kleiner als die Dicke des Kontaktierungsmaterials ist.

Des Weiteren ist es möglich, dass die Begrenzungsflächen mit der ersten Seite des Metallelements einen Winkel von mindestens 90° einschließen, um eine Positionierungsgeometrie zu bilden. Diese Positionierungsgeometrie ist für das einzubringende Kontaktierungsmaterial von Vorteil. Des Weiteren kann die Positionierungsgeometrie des Substratadapters zur Positionierung eines Halbleiters in Relation zum Kontaktierungsmaterial bzw. zum Metallelement dienen.

Der Rahmen aus elektrisch isolierendem Material und die Kavitäten bilden eine Art dreidimensionale Schablone zum Aufbringen des Kontaktierungsmaterials. Das Metallelement kann aus Kupfer oder einer Kupferlegierung gebildet sein. Diesbezüglich ist es denkbar, dass CuNi, CuSn, CuFe, CuNiSz, CuAg, CuW oder CuMo verwendet wird. Außerdem ist es möglich, dass das Metallelement aus reinem Silber besteht.

Ein weiterer nebengeordneter Aspekt der Erfindung betrifft ein Verfahren zum Kontaktieren eines Halbleiterelements, insbesondere eines Leistungsbauelements, mittels eines erfindungsgemäßen Substratadapters. Das erfindungsgemäße Kontaktierungsverfahren umfasst die Schritte:
- Ablösen eines vereinzelten Substratadapters, das ein Metallelement mit zusammengefügtem Kontaktierungsmaterial und einen Rahmen aus elektrisch isolierendem Material umfasst, von einem Träger,
- Positionieren des Substratadapters auf einem Halbleiterelement derart, dass das Kontaktierungsmaterial und das Halbleiterelement zueinander weisen,
- Anheften des Substratadapters auf dem Halbleiterelement durch Wärme- und/oder Druckbeaufschlagung, und
- Kontaktieren der zweiten Seite des optional beschichteten Metallelements mit einem Kontaktierungselement, insbesondere einem Bonddraht und/oder einem Bond-Bändchen und/oder einem Clip.

Der Bonddraht und/oder das Bond-Bändchen und/oder der Clip können aus reinem Kupfer oder einer Kupferlegierung bestehen. Diesbezüglich sind folgende Materialien denkbar: CuNi, CuSn, CuFn, CuNiSz, CuAg, CuW oder CuMo. Außerdem ist es möglich, das Kontaktierungselement aus reinem Silber herzustellen.

In einer weiteren Ausführungsform des erfindungsgemäßen Verfahrens zum Kontaktieren eines Halbleiterelements erfolgt, insbesondere vor dem Kontaktieren der zweiten Seite des Metallelements mit einem Kontaktierungselement, das Entfernen der Schutzfolie und Freilegen der zweiten Seite des Metallelements. Des Weiteren kann das erfindungsgemäße Kontaktierungsverfahren den Verfahrensschritt umfassen, dass der Substratadapter mit dem Halbleiterelement und/oder einem Substrat, das das Halbleiterelement umfasst, versintert und/oder verlötet und/oder verklebt wird.

Mit Hilfe des erfindungsgemäßen Verfahrens zur Herstellung eines Substratadapters sowie mit dem erfindungsgemäßen Substratadapter wird ein Substratadapter zur Verfügung gestellt, der zusammen mit dem Kontaktierungsmaterial einem Kunden und/oder einer Ver- bzw. Bearbeitungslinie zur Verfügung gestellt werden kann. Der Substratadapter kann auf einem Film-Frame bereitgestellt werden. In einer derartigen Lieferform kann der Substratadapter direkt in einem nächsten Prozess- bzw. Verfahrensschritt vom Film-Frame entnommen und auf ein Halbleiterelement, insbesondere auf ein Leistungsbauelement aufgebracht werden. Dies entspricht der sogenannten Pick-and-Place-Technologie, d.h. dass der Substratadapter mit Hilfe einer Robotik bzw. einer Greifvorrichtung oder einer Ansaugvorrichtung vom Film-Frame gelöst und zu dem entsprechenden Halbleiterelement transportiert werden kann.

Aufgrund des erfindungsgemäßen zumindest abschnittsweisen Ummanteln des strukturierten Metallelements wird eine verbesserte mechanische Verbindung zwischen einem Gate und einem Emitter zur Verfügung gestellt, so dass dieser Prozess durch ein steiferes Bauteil einfacher bewerkstelligt werden kann.

Nachfolgend wird die Erfindung anhand von Ausführungsbeispielen und unter Bezugnahme auf die beigefügten Zeichnungen mit weiteren Einzelheiten näher erläutert.

Hierbei zeigen:
- Fig. 1a, b: ein zumindest abschnittsweise mit Kunststoff ummanteltes Metallelement in einer Schnittdarstellung sowie einer Unteransicht,
- Fig. 2: ein mit Hilfe eines erfindungsgemäßen Substratadapters kontaktiertes Halbleiterelement,
- Fig. 3: eine weitere Ausführungsform eines erfindungsgemäßen Substratadapters, und
- Fig. 4: eine weitere Ausführungsform eines erfindungsgemäßen Substratadapters.

Im Folgenden werden für gleiche und gleich wirkende Teile gleiche Bezugsziffern verwendet.

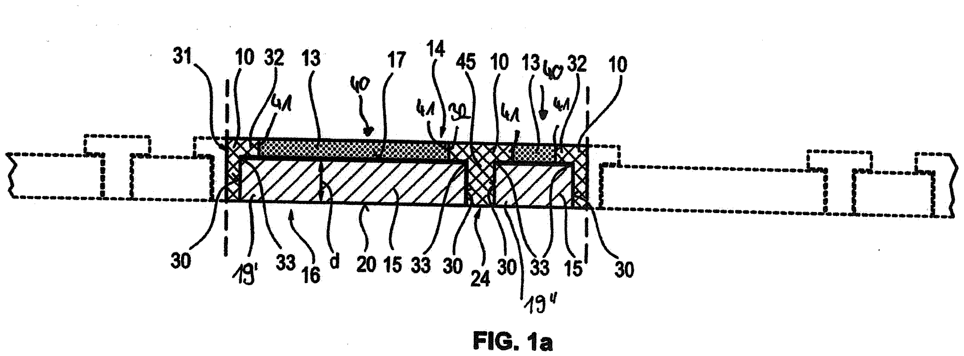

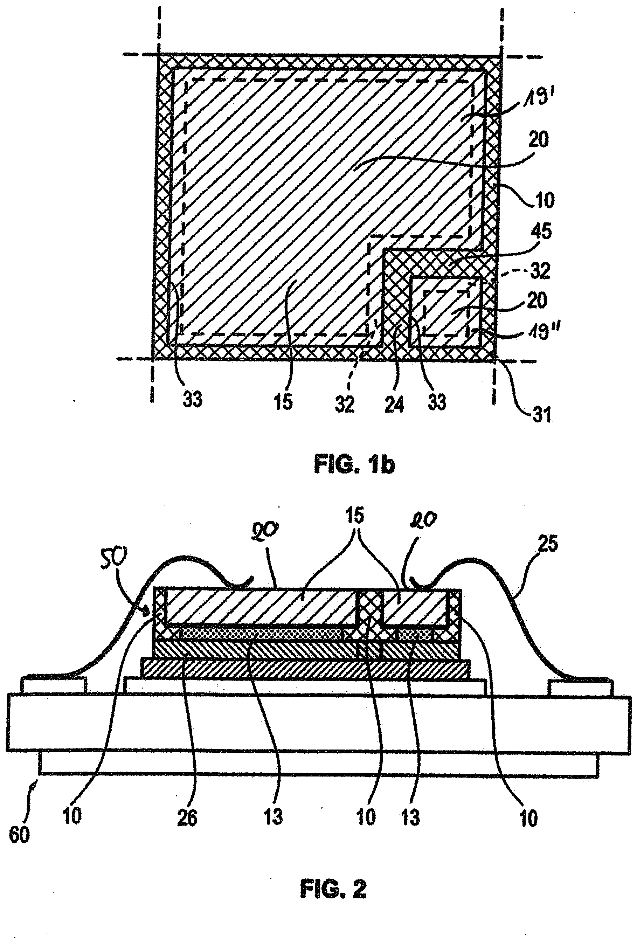

In Fig. 1a und 1b ist ein Metallelement 15, nämlich eine Kupferfolie dargestellt, die bereits strukturiert ist. Hierzu ist auf die erste Seite 17 des Metallelements 15 eine Trennstelle 24 eingearbeitet, wobei die Trennstelle 24 das Metallelement 15 auf der gesamten Dicke d trennt, so dass sich eine Struktur 16 auf der ersten Seite 17 des Metallelements 15 ergibt.

Es kann vorgesehen sein, dass ein Beschichten sowohl der ersten Seite 17 des Metallelements 15 als auch auf der zweiten Seite 20 des Metallelements 15 mit einem ersten Beschichtungssystem auf der ersten Seite 17 und einem zweiten Beschichtungssystem auf der zweiten Seite 20 erfolgt. Das optionale Beschichten eines strukturierten Metallelements 15 erfolgt demnach vorzugsweise nach dem Strukturieren des Metallelements 15. Das Beschichten der ersten Seite 17 sowie der zweiten Seite 20 des Metallelements 15 wird beispielsweise mittels Galvanisierung durchgeführt.

Das erste Beschichtungssystem und das zweite Beschichtungssystem sind vorzugsweise unterschiedliche Metalle, z.B. Nickel, Silber und/oder Gold.

Das strukturierte Metallelement 15 ist zumindest abschnittsweise mit elektrisch isolierendem Material 10, insbesondere Kunststoff, ummantelt. Die dargestellte Ummantelung des strukturierten Metallelements 15 mit elektrisch isolierendem Material 10 kann durch ein Transfermolden, insbesondere Film-Assist-Molden oder Thermo-Compression-Molden, oder durch ein Injection-Molden, insbesondere Mikrospritzen, erfolgen.

Beim Ummanteln des strukturierten Metallelements 15 sind zumindest abschnittsweise die dargestellten Seitenflächen 30 des Metallelements 15 mit elektrisch isolierendem Material 10 bedeckt, so dass ein Rahmen 31 aus elektrisch isolierendem Material 10 gebildet wird. Der Rahmen 31 umfasst zwischen zwei Abschnitten 19' und 19" des strukturierten Metallelements 15 mindestens einen Trennsteg 45 aus elektrisch isolierendem Material. Der Trennsteg 45 füllt mit anderen Worten die Trennstelle 24 auf. Die Abschnitte 19' und 19" des strukturierten Metallelements 15 bilden einen Gate sowie einen Emitter.

Der dargestellte Rahmen 31 hintergreift vollumfänglich die Kanten 33 der ersten Seite 17 des Metallelements 15. Aufgrund des vollumfänglichen Umschließens der Kanten 33 wird ein vollumfängliches Auflageelement 32 des Rahmens 31 gebildet. Dieses Auflageelement 32 sorgt für eine zusätzliche Stabilisierung des gebildeten Substratadapters. Die Auflageelemente 32 weisen Begrenzungsflächen 41 auf, welche zu einer Kavität 40 gehören. In die beiden dargestellten Kavitäten 40 ist ein Kontaktierungsmaterial 13 eingebracht.

Der Trennsteg 45 ist im dargestellten Beispiel höher als die Dicke d des Metallelements ausgebildet, so dass der Trennsteg 45 ebenfalls Auflageelemente 32 mit Begrenzungsflächen 41 bildet. Der Trennsteg 45 weist im dargestellten Querschnitt eine T-Form auf. Das auf die erste Seite 17 des Metallelements 15 aufgebrachte Kontaktierungsmaterial 13 kann beispielsweise durch Rakeln oder Sprayen oder Jetten oder Dispensen in die Kavitäten 40 aufgebracht werden. Bei einem Rakel-Vorgang dient der Rahmen 31 als Schablone bzw. Sieb für das auf die erste Seite 17 des Metallelements 15 aufzubringende Kontaktierungsmaterial 13. Das Kontaktierungsmaterial 13 ist beispielsweise eine silberhaltige bzw. silberlegierungshaltige Sinterpaste. Das Kontaktierungsmaterial 13 weist im aufgebrachten Zustand eine Struktur 14 auf, wobei die Struktur 14 der Struktur 16 des Metallelements 15 entspricht.

In Fig. 1a wird das ummantelte Metallelement 15 in einem mit einem Kontaktierungsmaterial 13 gefügten Zustand dargestellt. Es kann zusätzlich ein Fügen des strukturierten Metallelements 15 mit einem Träger erfolgen. Die gestrichelten Elemente verdeutlichen, dass mehrere Substratadapter, die ein Metallelement 15, einen äußeren Rahmen 31 und ein Kontaktierungsmaterial 13 umfassen, in einem Schritt gebildet werden können. Entlang der senkrecht gestrichelten Linien kann ein Vereinzeln des strukturierten und mit Kontaktierungsmaterial 13 versehenen Metallelements 15 zur weiteren Verarbeitung erfolgen, wobei die vereinzelten Metallelemente 15 beispielsweise auf einem Träger in einem Abstand zueinander fixiert sind. Das Vereinzeln kann durch Sägen und/oder Laserschneiden und/oder Stanzen und/oder Ätzen und/oder Wasserstrahl-Schneiden erfolgen.

Wie in Fig. 2 dargestellt ist, kann die zweite Seite des Metallelements 15 mit einem Kontaktierungselement 25, nämlich einem Kupfer-Bonddraht kontaktiert werden. Der Substratadapter 50 ist aufgrund eines üblichen Aufbau- und Verbindungsprozesses mit einem Halbleiterelement 26 eines Substrates 60 beispielsweise versintert.

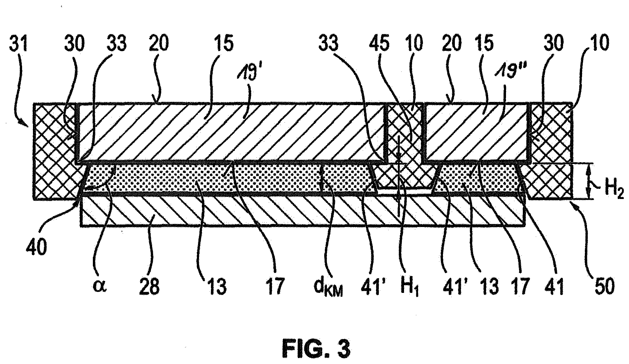

In Fig. 3 wird eine weitere Ausführungsform eines möglichen Substratadapters 50 dargestellt. Dieser Substratadapter 50 umfasst ein Metallelement 15 mit zwei Abschnitten 19' und 19". Das Metallelement 15 weist eine erste Seite 17 und eine zweite Seite 20 auf, wobei auf der ersten Seite 17 ein Kontaktierungsmaterial 13 aufgebracht ist. Ebenfalls dargestellt ist ein äußerer Rahmen 31 aus elektrisch isolierendem Material 10, der die Seitenflächen 30 des Metallelements 15 bedeckt. Die Seitenflächen 30 sind die Senkrechten bzw. Vertikalen zur ersten Seite 17 und zur zweiten Seite 20 des Metallelements 15. Die Seitenflächen 30 bestimmen die Dicke d des Metallelements 15. Außerdem umfasst der Rahmen 31 einen Trennsteg 45 aus elektrisch isolierendem Material 10. Der Rahmen 31 hintergreift die Kanten 33 der ersten Seite 17. Auf der ersten Seite 17 des Metallelements 15 sind zwei Kavitäten 40 mit Begrenzungsflächen 41, 41' gebildet, in die das Kontaktierungsmaterial 13 eingebracht ist.

Der Trennsteg 45 ist mit einer Begrenzungsfläche 41' verbunden, wobei die Höhe H₁ der Begrenzungsfläche 41' kleiner als die Dicke d_{KM} des Kontaktierungsmaterials 13 ist. Dies gilt für beide Begrenzungsflächen 41', die jeweils einer separierten Kavität 40 zugehören.

Die Höhe H₂ der Begrenzungsflächen 41 ist größer als die Dicke d_{KM} des Kontaktierungsmaterials 13. Die Höhe des Trennsteges 45 ist somit geringer als die Höhe der Abschnitte des Rahmens 31, die die Seitenflächen 30 des Metallelements 15 hintergreifen.

Die Begrenzungsflächen 41, 41' schließen mit der ersten Seite 17 des Metallelements 15 einen Winkel α ein, der einen Wert größer 90° aufweist, so dass eine Positionierungsgeometrie für das einzubringende Kontaktierungsmaterial 13 gebildet wird. In Fig. 3 ist ein Halbleiterelement 28 dargestellt, welches mit dem Kontaktierungsmaterial 13 verbunden ist. Auch hinsichtlich des Halbleiterelements 28 kann der Rahmen 31 eine Positionierungshilfe sein.

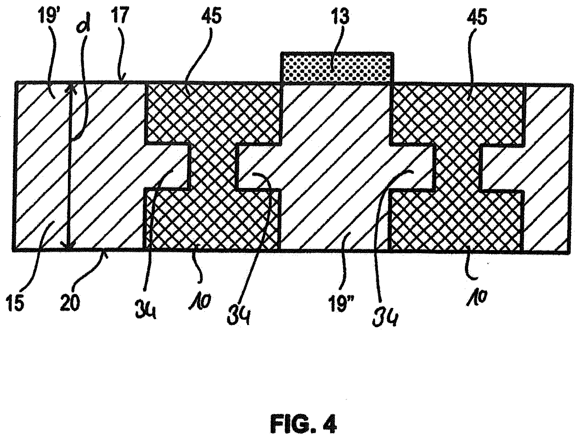

In Fig. 4 ist ein Abschnitt einer weiteren Ausführungsform hinsichtlich eines erfindungsgemäßen Substratadapters 50 dargestellt. Das Metallelement 15 umfasst ebenfalls zwei Abschnitte 19', 19". Die dargestellten Trennstege 45 weisen im Querschnitt eine H-Form auf. Die Trennstege 45 eines nicht weiter dargestellten Rahmens 31 sind somit das Negativ der in das Metallelement 15 eingebrachten Struktur. Die Struktur des Metallelements 15 weist gemäß Fig. 4 Absätze 34 auf. Die Absätze 34 werden vollständig vom elektrisch isolierenden Material 10 des Rahmens 31 bzw. der Trennstege 45 des Rahmens ummantelt. Die Höhe des Rahmens 31 bzw. der zum Rahmen zugehörigen Trennstege 45 entsprechen der Dicke d des Metallelements 15.

Auf der ersten Seite 17 des Metallelements 15 ist ein Kontaktierungsmaterial 13 aufgebracht. Das Kontaktierungsmaterial 13 kann in dieser Ausführungsform beispielsweise durch Siebdrucken oder Schablonendrucken bzw. durch indirektes Drucken auf die erste Seite 17 des Metallelements 15 aufgebracht werden.

### Bezugszeichenliste

- 10: elektrisch isolierendes Material
- 13: Kontaktierungsmaterial
- 14: Struktur Kontaktierungsmaterial
- 15: Metallelement
- 16: Struktur Metallelement
- 17: erste Seite Metallelement
- 19', 19": Abschnitt Metallelement
- 20: zweite Seite Metallelement
- 24: Trennstelle
- 25: Kupfer-Bonddraht
- 26: Halbleiterelement
- 28: Halbleiterelement
- 30: Seitenfläche des Metallelements
- 31: Rahmen
- 32: Auflageelement
- 33: umlaufende Kante des Metallelements
- 34: Absatz des Metallelements
- 40: Kavität
- 41, 41': Begrenzungsfläche
- 45: Trennsteg
- 50: Substratadapter
- 60: Substrat
- d: Dicke Metallelement
- d_{KM}: Dicke Kontaktierungsmaterial
- H₁, H₂: Höhe Begrenzungsfläche
- α: Winkel

## Patentansprüche

1. Verfahren zum Herstellen eines Substratadapters (50) nach Anspruch 9, der insbesondere zum Kontaktieren von Halbleiterelementen (26) dient, umfassend die Schritte:
- Strukturieren eines elektrisch leitenden Metallelements (15),
- zumindest abschnittsweises Ummanteln des strukturierten Metallelements (15) mit einem elektrisch isolierenden Material (10), insbesondere Kunststoff, und
- Aufbringen eines Kontaktierungsmaterials (13) auf eine erste Seite (17) des Metallelements (15),**gekennzeichnet durch** Fügen des strukturierten Metallelements (15) mit einem Träger und dem Kontaktierungsmaterial (13).

2. Verfahren nach Anspruch 1,
**gekennzeichnet durch**
Vereinzeln des strukturierten und mit Kontaktierungsmaterial (13) versehenen Metallelements (15) zur weiteren Verarbeitung derart, dass der Träger die vereinzelten Metallelemente (15) in einem Abstand zueinander fixiert.

3. Verfahren nach einem der vorhergehenden Ansprüche,
**dadurch gekennzeichnet, dass**
das zumindest abschnittsweise Ummanteln des strukturierten Metallelements (15) mit elektrisch isolierendem Material (10) durch ein Transfermolden, insbesondere Film-Assist-Molden oder Thermo-Compression-Molden, oder durch ein Injection-Molden, insbesondere Mikrospritzen, erfolgt.

4. Verfahren nach einem der vorhergehenden Ansprüche,
**dadurch gekennzeichnet, dass**
beim Ummanteln des strukturierten Metallelements (15) zumindest abschnittsweise Seitenflächen (30) des Metallelements (15) mit elektrisch isolierendem Material (10) bedeckt werden und ein Rahmen (31) aus elektrisch isolierendem Material (10) gebildet wird.

5. Verfahren nach Anspruch 4,
**dadurch gekennzeichnet, dass**
der Rahmen (31) auf der ersten Seite (17) des Metallelements (15) eine Kavität (40) mit Begrenzungsflächen (41, 41') bildet, in die das Kontaktierungsmaterial (13) eingebracht wird.

6. Verfahren nach Anspruch 5,
**dadurch gekennzeichnet, dass**
die Höhe mindestens einer der Begrenzungsflächen (41) kleiner (H₁) als die Dicke (d_{KM}) des Kontaktierungsmaterials (13) ist oder größer (H₂) als die Dicke (d_{KM}) des Kontaktierungsmaterials (13) ist oder der Dicke (d_{KM}) des Kontaktierungsmaterials (13) entspricht.

7. Verfahren nach einem der Ansprüche 6 bis 7,
**dadurch gekennzeichnet, dass**
die Begrenzungsflächen (41, 41') derart gebildet werden, dass diese mit der ersten Seite (17) des Metallelements (15) einen Winkel (α) von mindestens 90° einschließen, um eine Positionierungsgeometrie für das einzubringende Kontaktierungsmaterial (13) zu bilden.

8. Verfahren nach einem der Ansprüche 5 bis 7,
**dadurch gekennzeichnet, dass**
das Aufbringen des Kontaktierungsmaterials (13) direkt auf die erste Seite (17) des Metallelements (15) durch Rakeln oder Sprayen oder Jetten oder Dispensen in die mindestens eine Kavität (40) ausgeführt wird.

9. Substratadapter (50) umfassend ein Metallelement (15) mit einer ersten (17) und einer zweiten Seite (20), ein auf der ersten Seite (17) aufgebrachtes Kontaktierungsmaterial (13) und einen äußeren Rahmen (31) aus elektrisch isolierendem Material (10), der zumindest abschnittsweise Seitenflächen (30) des Metallelements (15) bedeckt,
**dadurch gekennzeichne**t, dass
auf der ersten Seite (17) des Metallelements (15) eine Kavität (40) mit Begrenzungsflächen (41, 41') gebildet ist, in die das Kontaktierungsmaterial (13) eingebracht ist.

10. Substratadapter (50) nach Anspruch 9,
**dadurch gekennzeichnet, dass**
der Rahmen (31) zwischen zwei Abschnitten (19', 19") des Metallelements (15) mindestens einen Trennsteg (45) aus elektrisch isolierendem Material (10) umfasst.

11. Substratadapter (50) nach Anspruch 9 oder 10,
**dadurch gekennzeichnet, dass**
der Rahmen (31) zumindest abschnittsweise Kanten (33) der ersten Seite (17) und/oder zweiten Seite (20) des Metallelements (15) hintergreift.

12. Substratadapter (50) nach einem der Ansprüche 9 bis 11,
**dadurch gekennzeichnet, dass**
die Höhe (H₁) mindestens einer der Begrenzungsflächen (41) kleiner als die Dicke (d_{KM}) des Kontaktierungsmaterials (13) ist oder größer (H₂) als die Dicke (d_{KM}) des Kontaktierungsmaterials (13) ist oder der Dicke (d_{KM}) des Kontaktierungsmaterials (13) entspricht.

13. Substratadapter (50) nach Anspruch 12,
**dadurch gekennzeichnet, dass**
mindestens ein Trennsteg (45) mit einer Begrenzungsfläche (41') verbunden ist, wobei die Höhe dieser Begrenzungsfläche (41') kleiner (H₁) als die Dicke (d_{KM}) des Kontaktierungsmaterials (13) ist.

14. Substratadapter (50) nach einem der Ansprüche 9 bis 13,
**dadurch gekennzeichnet, dass**
die Begrenzungsflächen (41, 41') mit der ersten Seite (17) des Metallelements (15) einen Winkel (α) von mindestens 90° einschließen, um eine Positionierungsgeometrie zu bilden.

15. Verfahren zum Kontaktieren eines Halbleiterelements (26), insbesondere eines Leistungsbauelements, mittels eines Substratadapters (50) nach einem der Ansprüche 9 bis 14, umfassend die Schritte:
- Ablösen eines vereinzelten Substratadapters (50), das ein Metallelement (15) mit zusammengefügtem Kontaktierungsmaterial (13) und einen Rahmen (31) aus elektrisch isolierendem Material umfasst, von einem Träger,
- Positionieren des Substratadapters (50) auf einem Halbleiterelement (26) derart, dass das Kontaktierungsmaterial (13) und das Halbleiterelement (26) zueinander weisen,
- Anheften des Substratadapters (50) auf dem Halbleiterelement (26) durch Wärme- und/oder Druckbeaufschlagung, und
- Kontaktieren der zweiten Seite (20) des optional beschichteten Metallelements (15) mit einem Kontaktierungselement, insbesondere einem Bonddraht (25) und/oder einem Bond-Bändchen und/oder einem Clip.

## Claims

1. Method for producing a substrate adapter (50) according to claim 9 used in particular for contacting semiconductor elements (26), comprising the steps:
- structuring of an electrically conducting metal element (15),
- encasing the structured metal material (15), at least in sections, with an electrically insulating material (10), more particularly plastic, and
- applying a contacting material (13) on a first side (17) of the metal element (15)
**characterised by** joining the structured metal element (15) to a carrier and the contacting material (13).

2. Method according to claim 1
**characterised by**
isolating the structured metal element (15) provided with contacting material (13) for further processing in such a way that the carrier fixes the isolated metal elements (15) at distance from one another.

3. Method according to any one of the preceding claims
**characterised in that** the encasing, at least in sections, of the structured metal element (15) with electrically insulating material (10) takes place through transfer moulding, in particular film-assist moulding or thermo-compression moulding, or through injection moulding.

4. Method according to any one of the preceding claims
**characterised in that** when encasing the structured metal element (15) at least in sections side surfaces (30) of the metal element (15) are covered with electrically insulating material (10) and a frame (31) of electrically insulating material (10) is formed.

5. Method according to claim 4
**characterised in that**
the frame (31) on the first side (17) of the metal element (15) forms a cavity (40) with boundary surfaces (41, 41') into which the coating material (13) is introduced.

6. Method according to claim 5
**characterised in that**
the height of at least one of the boundary surfaces (41) is smaller (H₁) than the thickness (d_{KM}) of the contacting material (13) or greater (H₂) than the thickness (d_{KM}) of the contacting material (13) or is the equivalent of the thickness (d_{KM}) of the contacting material (13).

7. Method according to any one of claims 6 to 7
**characterised in that**
the boundary surfaces (41, 41') are formed in such a way that with a first side (17) of the metal element (15) they form an angle (α) of at least 90° in order to form a positioning geometry for the contacting material (13) to be introduced.

8. Method according to any one of claims 5 to 7
**characterised in that**
the application of the contacting material (13) directly onto the first side (17) of the metal element (15) takes place by spreading or spraying or jetting or dispensing into the at least one cavity (40).

9. Substrate adapter (50) comprising a metal element (15) with a first (17) and a second side (20), a contacting material (13) applied to the first side (17) and an outer frame (31) made of an electrically insulating material (10) which at least in sections covers the side surfaces (30) of the metal element (15),
**characterised in that**
on the first side (17) of the metal element (15) a cavity (40) with boundary surfaces (41 41') is formed into which the contacting material (13) is introduced.

10. Substrate adapter (50) according to claim 9
**characterised in that**
between two sections (19', 19") of the metal element (15) the frame (31) comprises a separating web (45) of electrically insulating material (10).

11. Substrate adapter (50) according to claim 9 or 10
**characterised in that**
at least in sections the frame (31) engages behind edges (33) of the first side (17) and/or the second side (20) of the metal element (15).

12. Substrate adapter (50) according to any one of claims 9 to 11
**characterised in that**
the height (H₁) of at least one of the boundary surfaces (41) is smaller than the thickness (d_{KM}) of the contacting material (13) or greater (H₂) than the thickness (d_{KM}) of the contacting material (13) or is the equivalent of the thickness (d_{KM}) of the contacting material (13).

13. Substrate adapter (50) according to claim 12
**characterised in that**
at least one separating web (45) is connected to a boundary surface (41'), wherein the height of this boundary surface (41') is smaller (H₁) than the thickness (d_{KM}) of the contacting material (13).

14. Substrate adapter (50) according to any one of claims 9 to 13
**characterised in that**
the boundary surfaces (41, 41') form an angle (α) of at least 90° with the first side (17) of the metal element (15) in order to form a positioning geometry.

15. Method for contacting a semiconductor element (26), in particular a power component, by means of a substrate adapter (50) according to any one of claims 9 to 14, comprising the steps:
- detaching an isolated substrate adapter (50), comprising a metal element (15) with joined together contacting material (13) and a frame (31) of electrically insulating material, from a carrier,
- positioning of the substrate adapter (50) on a semiconductor element (26) in such a way that the contacting material (13) and the semiconductor element (26) face each other,
- attaching the substrate adapter (50) to the semiconductor element (26) through applying heat and/or pressure, and
- contacting of the second side (20) of the optionally coated metal element (15) with a contacting element, in particular a bond wire (25) and/or a bond band and/or a clip.

## Revendications

1. Procédé de fabrication d'un adaptateur de substrat (50) selon la revendication 9, qui sert en particulier à la mise en contact d'éléments semi-conducteurs (26), comprenant les étapes de :
- structuration d'un élément métallique électro-conducteur (15),
- enrobage au moins par section de l'élément métallique structuré (15) avec un matériau électro-isolant (10), notamment de la matière plastique, et
- application d'un matériau de contact (13) sur un premier côté (17) de l'élément métallique (15), **caractérisée par** l'assemblage de l'élément métallique structuré (15) avec un support et le matériau de contact (13).

2. Procédé selon la revendication 1,
**caractérisé par**
l'isolation de l'élément métallique (15) structuré et doté d'un matériau de contact (13) pour traitement ultérieur de telle manière que le support fixe les éléments métalliques isolés (15) à une distance les uns des autres.

3. Procédé selon l'une quelconque des revendications précédentes
**caractérisé en ce que**
l'enrobage au moins par section de l'élément métallique structuré (15) avec un matériau électro-isolant (10) a lieu par un moulage de transfert, notamment moulage assisté par film ou moulage par thermocompression ou par un moulage par injection, notamment par micro-injection.

4. Procédé selon l'une quelconque des revendications précédentes
**caractérisé en ce que**
lors de l'enrobage de l'élément métallique structuré (15), les surfaces latérales (30) de l'élément métallique (15) sont couvertes au moins par section avec un matériau électro-isolant (10) et un cadre (31) en matériau électro-isolant (10) est formé.

5. Procédé selon la revendication 4,
**caractérisé en ce que**
le cadre (31) forme sur le premier côté (17) de l'élément métallique (15) une cavité (40) avec des surfaces de délimitation (41, 41') dans lesquelles est introduit le matériau de contact (13).

6. Procédé selon la revendication 5,
**caractérisé en ce que**
la hauteur d'au moins une des surfaces de délimitation (41) est plus petite (H₁) que l'épaisseur (d_{KM}) du matériau de contact (13) ou plus grande (H₂) que l'épaisseur (d_{KM}) du matériau de contact (13) ou correspond à l'épaisseur (d_{KM}) du matériau de contact (13) .

7. Procédé selon l'une quelconque des revendications 6 à 7,
**caractérisé en ce que**
les surfaces de délimitation (41, 41') sont formées de telle manière que celles-ci forment avec le premier côté (17) de l'élément métallique (15) un angle (α) d'au moins 90°, pour former une géométrie de positionnement pour le matériau de contact (13) à introduire.

8. Procédé selon l'une quelconque des revendications 5 à 7,
**caractérisé en ce que**
l'application du matériau de contact (13) est directement exécutée sur le premier côté (17) de l'élément métallique (15) par râclage ou pulvérisation ou par jet ou distribution dans au moins une cavité (40) .

9. Adaptateur de substrat (50) comprenant un élément métallique (15) avec un premier (17) et un deuxième côté (20), un matériau de contact (13) appliqué sur le premier côté (17) et un cadre extérieur (31) en matériau électro-isolant (10), qui couvre au moins par section les surfaces latérales (30) de l'élément métallique (15),
**caractérisé en ce que**
sur le premier côté (17) de l'élément métallique (15) est formée une cavité (40) avec des surfaces de délimitation (41, 41') dans laquelle le matériau de contact (13) est introduit.

10. Adaptateur de substrat (50) selon la revendication 9,
**caractérisé en ce que**
le cadre (31) entre deux sections (19', 19") de l'élément métallique (15) comprend au moins une nervure de séparation (45) en matériau électro-isolant (10).

11. Adaptateur de substrat (50) selon la revendication 9 ou 10,
**caractérisé en ce que**
le cadre (31) vient en prise par l'arrière au moins par section avec les bords (33) du premier côté (17) et/ou du deuxième côté (20) de l'élément métallique (15).

12. Adaptateur de substrat (50) selon l'une quelconque des revendications 9 à 11,
**caractérisé en ce que**
la hauteur (H₁) au moins d'une des surfaces de délimitation (41) est inférieure à l'épaisseur (d_{KM}) du matériau de contact (13) ou supérieure (H₂) à l'épaisseur (d_{KM}) du matériau de contact (13) ou correspond à l'épaisseur (d_{KM}) du matériau de contact (13) .

13. Adaptateur de substrat (50) selon la revendication 12,
**caractérisé en ce qu'**
au moins une nervure de séparation (45) est reliée à une surface de délimitation (41'), sachant que la hauteur de cette surface de délimitation (41') est inférieure (H₁) à l'épaisseur (d_{KM}) du matériau de contact (13).

14. Adaptateur de substrat (50) selon l'une quelconque des revendications 9 à 13,
**caractérisé en ce que**
les surfaces de délimitation (41, 41') forment avec le premier côté (17) de l'élément métallique (15) un angle (α) d'au moins 90° pour former une géométrie de positionnement.

15. Procédé de mise en contact d'un élément semi-conducteur (26), en particulier d'un composant de puissance, au moyen d'un adaptateur de substrat (50) selon l'une quelconque des revendications 9 à 14, comprenant les étapes de
- détachement depuis un support d'un adaptateur de substrat isolé (50), qui comprend un élément métallique (15) avec un matériau de contact assemblé (13) et un cadre (31) en matériau électro-isolant,
- positionnement de l'adaptateur de substrat (50) sur un élément semi-conducteur (26) de telle manière que le matériau de contact (13) et l'élément semi-conducteur (26) sont tournés l'un vers l'autre,
- fixation de l'adaptateur de substrat (50) sur l'élément semi-conducteur (26) par application de chaleur et/ou de pression, et
- mise en contact du deuxième côté (20) de l'élément métallique revêtu en option (15) avec un élément de contact, notamment un fil de liaison (25) et/ou une bande de liaison et/ou une agrafe.
